# EUROPEAN PATENT APPLICATION

(11) **EP 2 381 749 A1**
(43) Date of publication of application: **26.10.2011**
(21) Application number: 10161052.5
(22) Date of filing: 26.04.2010
(51) Int. Cl.: H05K 1/14

(54) **Device for forming a conductive connection between an electric conductor and an electric conducting part of a carrier and assembly of the device and a carrier**

(71) Applicant: Alrack B.V., 5504 PA Vedhoven (NL)
(72) Inventor: Trimpe, Cornelis Johannes, 5506 BH, Veldhoven (NL)
(74) Representative: Eveleens Maarse, Pieter

(57) **Abstract**

The invention relates to a device for forming a conductive connection between an electric conductor and an electric conducting part of a carrier, comprising first and second cooperating connecting members, wherein the first connecting member comprises a support for supporting the carrier at a first side of the carrier, and wherein the first and second connecting members are mutually displaceable between an open position, wherein the carrier can be positioned onto the support and wherein the conductor can be positioned onto a second side of the carrier opposite to the first side, and a closed position, wherein the first connecting member exerts a force to the second connecting member towards the first connecting member for urging the electric conductor towards the second side of the carrier.

## Description

The invention relates to a device for forming a conductive connection between an electric conductor and an electric conducting part of a carrier. The invention also relates to an assembly of a device according to the invention and a carrier connected to the device.

Conducting connections between a conductor and a conducting part of a carrier, such as a Printed Circuit Board (PCB), are present in almost any electric apparatus and for any kind of application. PCB's are standardized carriers and are commonly made of a composite of glass-fibres embedded in an epoxy matrix. The connections in electric apparatuses are subject to various conditions. Examples of such apparatuses are photovoltaic panels or modules, which are commonly located at roofs of a building and must be conductively connectable to one or more batteries or to the AC. It may be required to repair or modify the electric apparatus in case of malfunctioning. However, such connections are commonly based on solder, which leads to time-consuming repairs and/or modifications. This holds particularly in case of installation or repair of photovoltaic panels, which is not without risk and should be feasible in a simple and reliable manner. In addition, it is known that an increase in pressure between the conductor and the carrier may lead to an increase in conductive capacity. However, a solder joint provides metallic contact but it cannot press a conductor against the carrier. An alternative is to glue a clamp onto the carrier, which clamp is designed for pressing the conductor against the carrier. However, either the glue or the carrier may loosen its stiffness and strength, leading to a decrease of conductive capacity between the conductor and the carrier. As a result, the conductive capacity of the connection between the conductor and the carrier will often be overdimensioned and hence may be underused.

It is an object of the present invention to provide a device for forming a conductive connection between an electric conductor and an electric conducting part of a carrier, which at least partly overcomes the above-mentioned disadvantages.

According to the invention, one of the objects is achieved by a device for forming a conductive connection between an electric conductor and an electric conducting part of a carrier, comprising first and second cooperating connecting members, wherein the first connecting member comprises a support for supporting the carrier at a first side of the carrier, and wherein the first and second connecting members are mutually displaceable between open positions, wherein the carrier can be positioned onto the support and wherein the conductor can be positioned onto a second side of the carrier opposite to the first side, and a closed position, wherein the first connecting member exerts a force to the second connecting member towards the first connecting member for pushing the electric conductor towards the second side of the carrier. The device according to the invention not only allows easy replacement of a conductor, but also may lead to improved conductive capacity, as the conductor is pressed against the electric conductive part of the carrier. As the first connecting member of the device according to the invention exerts a force to the second connecting member towards the first connecting member for pushing the electric conductor towards the second side of the carrier, the level at which the conductor is pressed against the second side of the carrier is not or at least very limited influenced by the material properties of the carrier. The easy replacement and improved conductive capacity are particular advantageous in case of the use in a solar panel. Solar panels are commonly installed on roofs, which roofs can extend under an angle with the horizontal and at a considerable height and replacement or repair is therefore not without risk and should be performed in a short and simple manner, which is enabled by the device according to the invention. In particular the clamping according to the invention avoids the use of soldering.

Although it is not excluded that the first and second connecting member are mutually displaceable in the closed position, the device preferably comprises latching means, for mutually latching the first and second connecting members in the closed position. By latching the first and second connecting members in the closed position, a reliable connection between the conductor and the carrier is obtained.

In an embodiment the second connecting member comprises a resilient body, for pressing the conductor against the second side of the carrier in the closed position. Pressing allow for obtaining a controlled pressure for pressing the conductor against the carrier. Pressure means can be designed in various ways. It can be a separate part, such as an elastic deformable body, a spring etc. Preferably, the second connecting member comprises an elastic deformable element, such as a folded part of a plate from which the second connecting member can be manufactured from, wherein in the open position the element is located at a distance from the carrier for positioning the conductor onto the second side of the carrier and wherein in the closed position the element is at least partly deformed under influence of the conductor and/or the carrier for pressing the conductor against the second side of the carrier. This not only leads to a simple design and use of the device, but also to a controlled pressure of the element against the conductor. Further, by mutually displacing the first and second connecting member, the element follows the orientation of the second connecting member and therefore allows for adjusting the device by orienting the element relative to the second connecting member for creating the desired pressure onto the conductor in the closed position.

In another embodiment, the second connecting member comprises two elastic deformable elements, wherein in the open position the elements are located at a distance from the carrier for positioning the conductor onto the second side of the carrier and wherein in the closed position the elements are at least partly located nearby or against the second side of the carrier for pressing the conductor against the second side of the carrier at two spaced apart locations of the conductor. This improves handling of the device for connecting a conductor to the carrier and decreases the risk that the conductor may come loose during use. By pressing the conductor against the second side of the carrier at two spaced apart locations of the conductor, a conductor with smaller dimensions can be connected to the carrier, while still being pressed against the carrier. Preferably, in the closed position the elements make an angle with the carrier which is substantially different form perpendicular. This provides the device with a certain damage tolerance and provides a controlled increase of pressure during mutually displacing the first and second connecting members towards the closed position.

The free end of the element can be designed as a flat surface. In a preferred embodiment, the at least one element comprises a recess at a free end of the element for receiving at least a part of the conductor. In this way the at least one element is designed for receiving a conductor which has a cross section with a certain height, such as the core of a conductor cable. In addition, the edge of the element will exert a high pressure or even cut itself partly into the insulating mantle of the conductor cable, which increases the strength of the connection between the conductor and the carrier.

In a simple design the first and second connecting members are hingedly connected. In another preferred embodiment, at a distance from the hingedly connection between the first and second connecting member, one connecting member comprises at least one recess and the other connecting member comprises at least one hook, wherein in the closed position the hook at least partly extends in the recess. This results in a reliable and easy way of latching the first and second connecting member.

In yet another embodiment, the at least one recess is at least partly located in a part of the one member extending substantially perpendicular to the support, which part of the one connecting member is positionable through a passage in the carrier, such that the recess at least partly extends beyond the passage. In this way, the carrier is at least partly hold between the first and second connecting member in the closed position. As a result the conductor is pressed against the carrier in between the first and second connecting member, which is reliable and strong as the pressure is not or almost not influenced by the properties of the carrier. Preferably, the end of the recess is located at a distance from the support larger than the thickness of the carrier. This allows the hook to be positioned into the recess at the side where the member having the recess is located. This increases the handling of the device, as a user can easily visualize whether the latching between the first and second connecting is obtained. By locating the recess in a part extending substantially perpendicular to the support a rigid latching is obtain as the stiffness in longitudinal direction of the part is larger than the bending stiffness of the part. Preferably, the other connecting member comprises a guiding surface for guiding the at least part of the hook into the recess. This further improves latching of the first and second connecting member.

To improve reliable positioning of the first connecting member relative to the carrier, the first connecting member comprises at least one slot for receiving an edge of the carrier. By positioning the carrier into the slot an unambiguously position of the carrier relative to the first connecting member is obtained. The first connecting member can also comprise a first and second slot at a distance of the first slot, for holding the carrier at an outside edge of the carrier an edge of a passage of the carrier.

In a further embodiment, the device comprises securing means, for mutually securing the first and second connecting members in at least one open position. This results in an unambiguously position of the first and second connecting member, which allows a user to easily replace or position a new conductor onto the carrier, without the risk of unwanted mutual displacement of the first and second connecting member towards de closed position. The securing means preferably comprise a projection in one connecting member and a recess in the other connection member for receiving the projection at a distance from the hingedly connection between the first and second connecting member.

Although it is not excluded that the first and/or second connecting member are assembled from various parts, preferably, the first and/or second connecting member are each separately integrally formed. This allows for relatively cheap manufacture of the first and/or second connecting member. In addition, the strength of the first and/or second connecting member may increase, as there are no or at least fewer weak connections in the first and/or second connection member.

Although the first and/or second connection member can be manufactured from various materials, the first and/or second connection member is preferably substantially manufactured from a material selected from the group consisting of: steel, steel alloy, stainless steel, plastic. These materials combine low weight with high strength and allow for relative easy manufacture of the first and/or second connecting member.

The invention also provides an assembly comprising a device according to any of the preceding claims and a carrier, which carrier is at least partly made of an insulating material, wherein the carrier at its first side is supported by the support of the first connecting member.

In a preferred embodiment the carrier comprises at least one passage, wherein an edge of the carrier is received in the slot of the first connecting member and in that the part of the one connecting member extending substantially perpendicular to the support in which the recess is located extends through the carrier, such that the recess at least partly extends beyond the passage.

The invention further provides a junction box for enclosing an electrically conductive connection with at least one conductor and an electric conducting part of a carrier, comprising a housing, provided with at least one first opening for passing the at least one conductor into the internal of the housing and at least one second opening for providing access into the housing for connecting the at least one conductor with the carrier, an assembly according the invention and positioning means for positioning the carrier within the housing. The positioning means can be an edge or ridge with latching means for latching the carrier relative to the housing.

The advantages of the assembly and the junction box according to the invention are similar to the advantages of the device for forming a conductive connection between an electric conductor and an electric conducting part of a carrier according to the invention, as described above.

The invention will now be further elucidated with reference to the following schematic figures, without however being limited thereto. In the figures, similar references are used for similar components.
Figure 1 shows a perspective view of a device for forming a conductive connection between an electric conductor and an electric conducting part of a carrier according to the invention in an open position;
Figure 2 shows a perspective view of the first connecting member of the device of figure 1;
Figure 3 shows a perspective view of the second connecting member of the device of figure 1;
Figure 4 shows a side view of the device of figure 1 in an open position;
Figure 5 shows a side view of the device of figure 1 in the closed position;
Figure 6 shows a perspective view of another embodiment of a device for forming a conductive connection between an electric conductor and an electric conducting part of a carrier according to the invention in an open position; and
Figures 7a - 7e show the functioning of the device of figure 1.

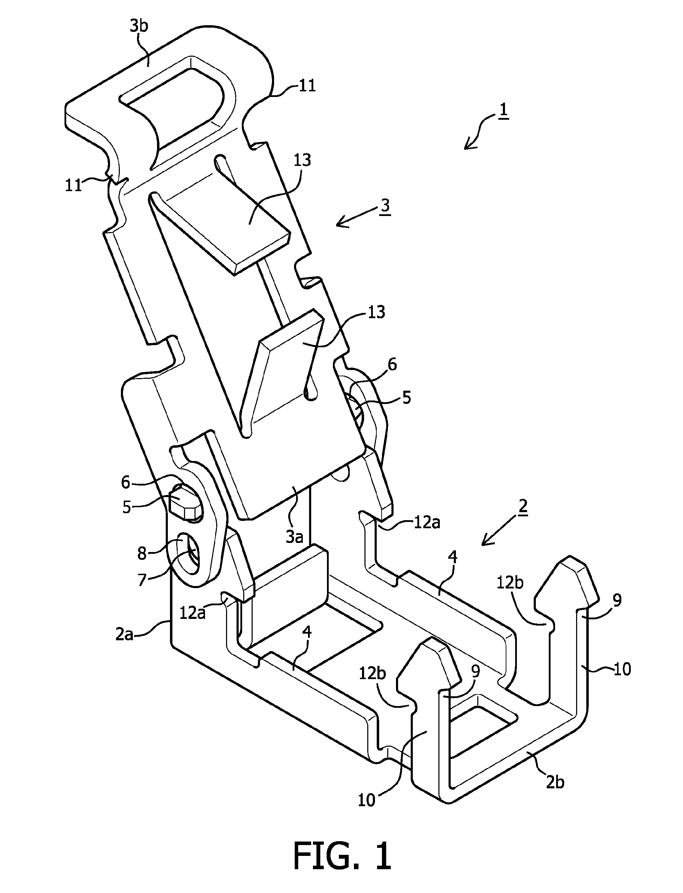

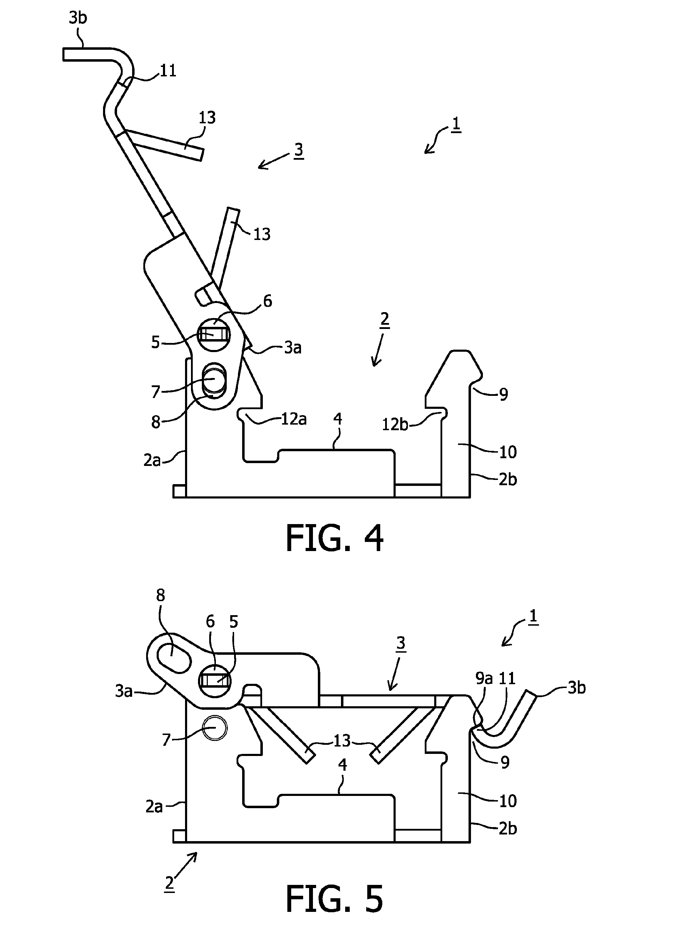

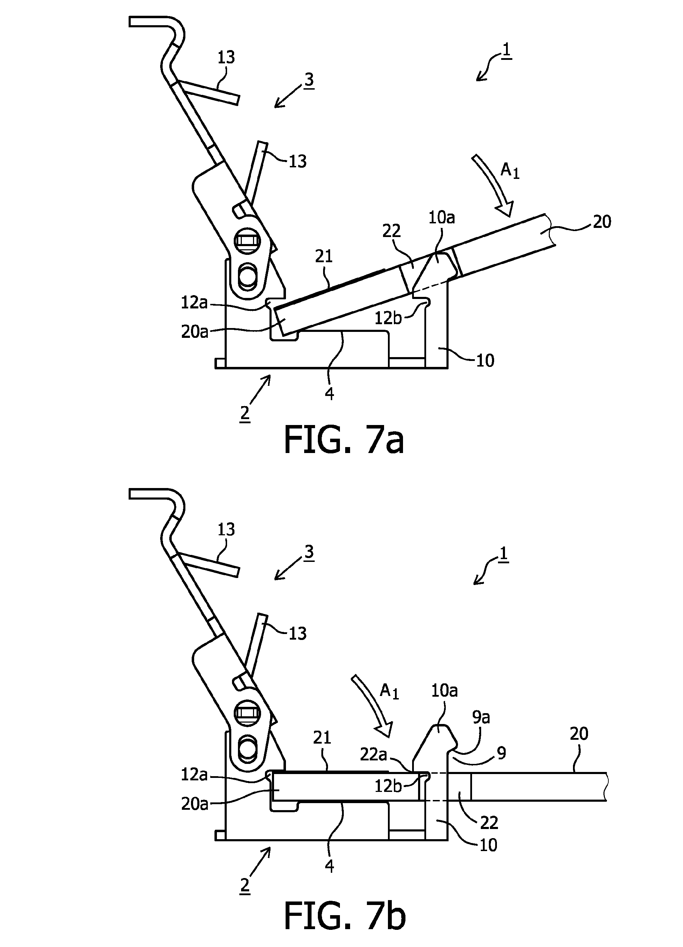

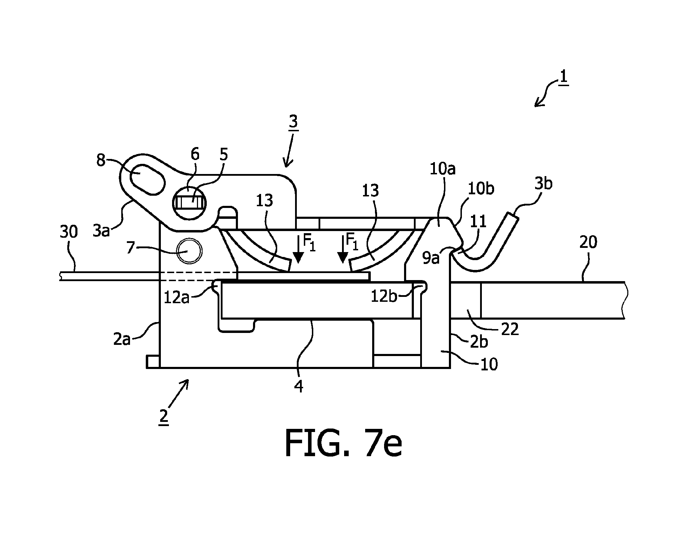

With reference to figure 1, a device 1 for forming a conductive connection between an electric conductor and an electric conducting part of a carrier (see figure 7e) is shown. The device 1 comprises a first connecting member 2 and a second connecting member 3. The connecting members 2,3 are each separately integrally formed out of a plate manufactured from stainless steel, although the connecting members 2,3 can also be formed out of a plate manufactured from copper or copper alloy or other suitable conductive or insulating materials. The first connection member 2 comprises a support 4 for supporting the carrier at a first side of the carrier (see figure 7e). Further, the first connecting member 2 comprises first projections 5 at a first side 2a of the first connecting member 2 and the second connecting member 3 comprises first recesses 6 at a first side 3a of the second connecting member 3 for hingedly connecting the first connecting member 2 and second connecting member 3. The connecting members 2,3 are mutually displaceable between open positions and a closed position. The first connecting member 2 comprises second projections 7, at a distance from the first projections 5, and the second connecting member 3 comprises second recesses 8, at a distance from the first recesses 6. In the open position as shown in figure 1, the second projections 7 extend in the recesses 8, for mutually securing the connecting members 2,3 in the open position as shown in figure 1. At a second side 2b of the first connecting member 2, the first connecting member 2 comprises two recesses 9, located in wall sections 10, which wall sections 10 extend perpendicular to the support 4. The wall sections 10 are positionable through a passage in the carrier, such that the recess at least partly extends beyond the passage (see figures 7a - 7e). At a second side 3b of the second connecting member 3, the second connecting member 3 comprises two hooks 11. In the closed position the hooks 11 at least partly extends in the recesses 9 (see figure 5). The first connecting member 2 also comprises a first slot 12a near the first side 2a and a second slot 12b near the second side 2b for receiving an edge of the carrier (see figure 7e). The first connecting member 2 further comprises two elastic deformable elements 13. The elastic deformable elements 13 are folded parts of the plate of stainless steel from which the second connecting member 13 are manufactured from. The elements 13 extend under angle towards the support 4 in the closed position (see also figure 5), for pressing the conductor towards the carrier at two spaced apart locations of the conductor (see figures 7a - 7e).

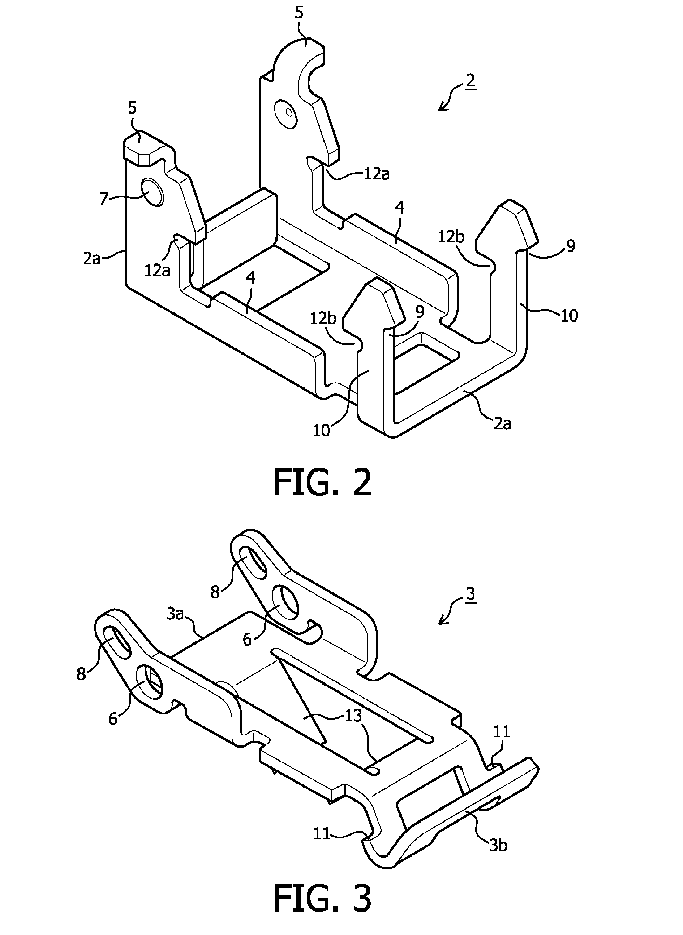

With reference to figure 2 and 3, the first connecting member 2 and second connection member 3 are shown, respectively. From these figures it is clear that the connecting members 2,3 are each separately integrally formed and that they comprises multiple wall sections

With reference to figure 4, a side view of the device 1 of figure 1 is shown, wherein the first connecting member 2 and the second connecting member 3 are mutually hingedly connected and are shown in the open position. In the open position as shown, the first connecting member 2 and the second connecting member 3 are mutually secured, as the second projections 7 of the first connecting member 2 extend in the recesses 9 of the first connecting member 2. The hooks 11 abut an edge 9a of the recess 9, which are part of the wall section 10.

With reference to figure 5, a side view of the device 1 of figure 1 is shown, wherein the first connecting member 2 and the second connecting member 3 are mutually hingedly connected and are shown in the closed position. In the closed position as shown, the first connecting member 2 and the second connecting member 3 are mutually latched, as the hooks 11 of the second connecting member 3 extend in the recesses 8 of the second connecting member 3.

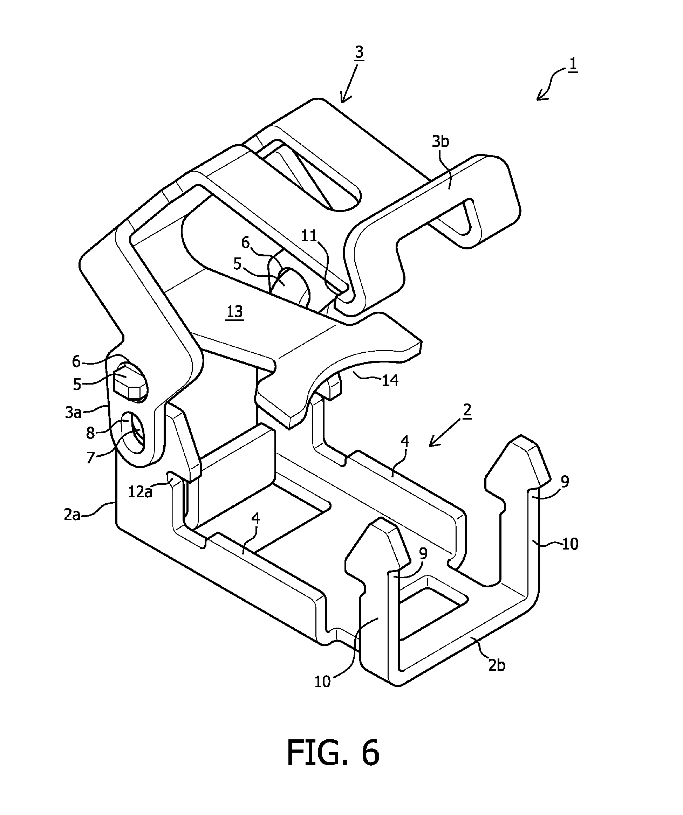

With reference to figure 6 an embodiment of the device 1 according to the invention is shown. The embodiment of the device 1 as shown in this figure 6 differs from the embodiment of the device 1 as shown in figure 1 in that the second connecting member 3 only comprises one elastic deformable element 13, which extends from the first side 3a of the second connecting member 3. Similar to the embodiment of the device 1 as shown in figure 1, the element 13 extends under angle towards the support 4 in the closed position. In addition, the element 13 comprises a recess at a free end 13a of the element 13 for receiving at least a part of the conductor. In this way, the core of a conductor cable can be pressed against the carrier. In the embodiment of the device 1 shown, the recess 14 is formed as a concavity.

The functioning of the device will be elucidated with reference to figures 7a - 7e.

As shown in figure 7a, a carrier 20, provided with a conducting layer 21, is positioned onto the first connecting member 2, such that an outer edge 20a of the carrier 20 at least partly extend in the slot 12a. By then rotating the carrier 20 corresponding the arrow A1 towards the support 4, an end 10a of the wall section 10 at least partly extends through a passage 22 of the carrier 20.

By further rotating the carrier 20 corresponding the arrow A1 towards the support 4, the part of the carrier 20, which extends below the conducting layer 21, is supported by the support 4 (see figure 7b). The outer edge 20a of the carrier extends in the slot 12a. An edge 22a of the passage 22 extends in the slot 12b. In this way the carrier 20 is unambiguously positioned relatively to the first connecting member 2. The end 10a of the wall section 10 extends through a passage 21 of the carrier 20, such that also the recess 9 at least partly extends through the passage 22. Also, the edge 9a of the recess 9 extends above the carrier 20.

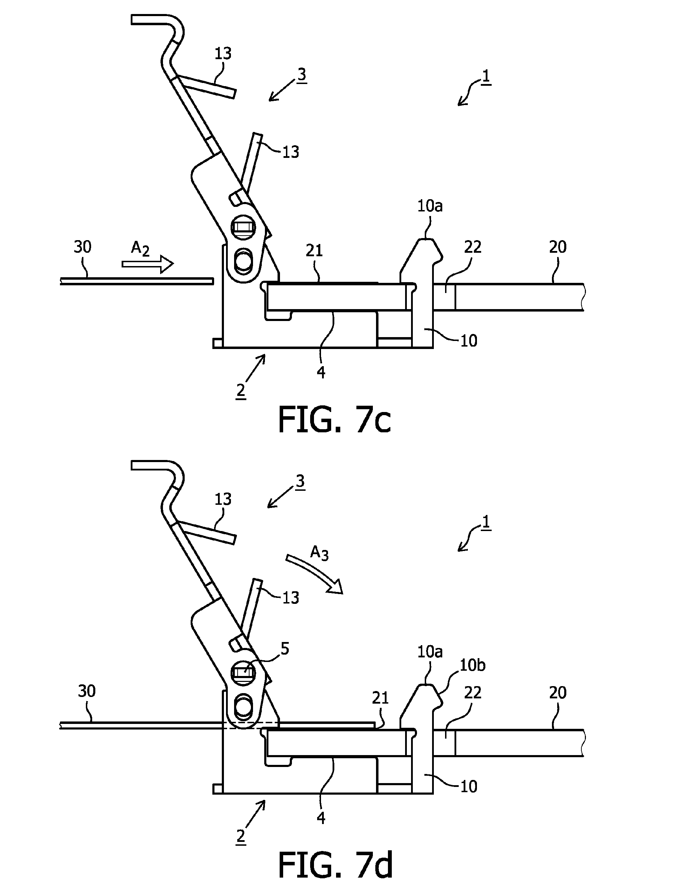

As shown in figure 7c, a conductor 30 formed as a ribbon can now be positioned at the desired location onto the carrier 20. Thereto the conductor 30 is positioned in between the first connecting member 2 and the second connecting member 3 corresponding arrow A2, as shown in this figure.

As the conductor 30 is positioned at the desired location, the second connecting member 3 can be displaced relative to the first connecting member 2 corresponding arrow A3 as shown in figure 7d. The first connecting member 2 is rotated around hinge 5, wherein the elements 13 move towards the conductor 30 and the carrier 20. After rotating the second connecting member 3 a certain degrees relative to the second connecting member 2, the elements 13 will contact the conductor 30. After further rotating the second connecting member 3 relative to the first connecting member 2, the elements 13 will deform, as the carrier 20, on which the conductor 30 is positioned, is supported by the support 4.

By continuing the rotation corresponding arrow A3, the hooks 11 will guide along an edge 10b at the end 10a of the wall section 10, thereby deforming the second side 3b of the second connecting member 3. The hooks 11 will then extend into the recess 9 and abut the edge 9a of the recess 9.The first connecting member 2 and the second connecting member 3 are mutually latched. In between the first connecting member 2 and the second connecting member 3 the conductor is pressed against the conducting part 21, under influence of a force F1 exerted by the elements 13 of the carrier 20, leading to a good conductive capacity between the conductor 30 and the conducting part 21 of the carrier 20.

## Claims

1. Device for forming a conductive connection between an electric conductor and an electric conducting part of a carrier, comprising first and second cooperating connecting members,
wherein the first connecting member comprises a support for supporting the carrier at a first side of the carrier, and
wherein the first and second connecting members are mutually displaceable between an open position, wherein the carrier can be positioned onto the support and wherein the conductor can be positioned onto a second side of the carrier opposite to the first side, and a closed position, wherein the first connecting member exerts a force to the second connecting member towards the first connecting member for urging the electric conductor towards the second side of the carrier.

2. Device according to claim 1, **characterized in that** the device comprises latching means, for mutually latching the first and second connecting members in the closed position.

3. Device according to claim 1 or 2, **characterized in that** the second connecting member comprises a resilient body, for pressing the conductor against the second side of the carrier in the closed position.

4. Device according to claim 3, **characterized in that** the second connecting member comprises an elastic deformable element, wherein in the open position the element is located at a distance from the carrier for positioning the conductor onto the second side of the carrier and wherein in the closed position the element is at least partly deformed under influence of the conductor and/or the carrier for pressing the conductor against the second side of the carrier

5. Device according to claim 4, **characterized in that** the second connecting member comprises two elastic deformable elements, wherein in the open position the elements are located at a distance from the carrier for positioning the conductor onto the second side of the carrier and wherein in the closed position the elements are at least partly located nearby or against the second side of the carrier for pressing the conductor against the second side of the carrier at two spaced apart locations of the conductor.

6. Device according to claims 4 or 5, **characterized in that** at least one element comprises a recess at a free end of the element for receiving at least a part of the conductor.

7. Device according to any of the preceding claims, **characterized in that** the first and second connecting members are hingedly connected and **in that** at a distance from the hingedly connection between the first and second connecting member, one connecting member comprises at least one recess and the other connecting member comprises at least one hook, wherein in the closed position the hook engages the recess.

8. Device according to claim 7, **characterized in that** the at least one recess is at least partly located in a part of the one member extending substantially perpendicular to the support, which part of the one connecting member is positionable through a passage in the carrier, such that the recess at least partly extends beyond the passage.

9. Device according to any of the preceding claims, **characterized in that** the first connecting member comprises at least one slot for receiving an edge of the carrier.

10. Device according to claim 9, **characterized in that** the device comprises securing means, for mutually securing the first and second connecting members in at least one open position.

11. Device according to any of the preceding claims, **characterized in that** the first and/or second connecting member are each separately integrally formed.

12. Device according to any of the preceding claims, **characterized in that** the first and/or second connecting member is substantially manufactured from a material selected from the group consisting of: steel, steel alloy, stainless steel, plastic.

13. Assembly comprising at least one device according to any of the preceding claims and a carrier, which carrier is at least partly made of an insulating material, wherein the carrier at its first side is supported by the support of the first connecting member.

14. Assembly according to claim 13, **characterized in that** the carrier comprises at least one passage, wherein an edge of the carrier is received in the slot of the first connecting member and **in that** the part of the one connecting member extending substantially perpendicular to the support in which the recess is located extends through the carrier, such that the recess at least partly extends beyond the passage.

15. Junction box for enclosing an electrically conductive connection with at least one conductor and an electric conducting part of a carrier, comprising:
- a housing, provided with at least one first opening for passing the at least one conductor into the internal of the housing and at least one second opening for providing access into the housing for connecting the at least one conductor with the carrier;
- an assembly according to claim 13 or 14; and
- positioning means for positioning the carrier within the housing.
